Europäisches Patentamt

European Patent Office

Office européen des brevets

(19)

(11) EP 0 346 404 B2

(12) NEUE EUROPÄISCHE PATENTSCHRIFT

(45) Veröffentlichungstag und Bekanntmachung des Hinweises auf die Entscheidung über den Einspruch:
14.07.1999 Patentblatt 1999/28

(45) Hinweis auf die Patenterteilung:
11.08.1993 Patentblatt 1993/32

(21) Anmeldenummer: 88909078.3

(22) Anmeldetag: 22.10.1988

(51) Int Cl.$^6$: G01R 31/36, H01M 10/48

(86) Internationale Anmeldenummer:
PCT/DE88/00647

(87) Internationale Veröffentlichungsnummer:
WO 89/04000 (05.05.1989 Gazette 1989/10)

(54) **Verfahren zur Ermittlung des Energieinhaltswertes von elektrochemischen Energie-speichern**

Process for determining the energy content of an electrochemical storage battery

Procede pour determiner le contenu energetique d' accumulateurs electrochimiques

(84) Benannte Vertragsstaaten:
CH FR GB IT LI SE

(30) Priorität: 28.10.1987 DE 3736481

(43) Veröffentlichungstag der Anmeldung:
20.12.1989 Patentblatt 1989/51

(73) Patentinhaber: GRÄSSLIN KG
D-78104 St. Georgen/Schwarzwald (DE)

(72) Erfinder:
• BLESSING, Andreas
D-7742 St. Georgen (DE)

• GRISS, Jochen
D-7742 St. Georgen (DE)
• KAMMERER, Gerd
D-7298 Lossburg (DE)

(74) Vertreter: Thoma, Friedrich, Dipl.-Ing.(FH)
Buchenstrasse 20
77716 Haslach (DE)

(56) Entgegenhaltungen:
DE-A- 3 018 981          DE-A- 3 116 371
DE-A- 3 216 412          DE-B- 2 926 716
DE-C- 3 031 898          DE-C- 3 407 409
US-A- 4 204 162

**Beschreibung**

Die Erfindung betrifft ein Verfahren zur Ermittlung des Energieinhaltswertes von elektrochemischen Energiespeichern, mit den Merkmalen nach dem ersten Teil des Patentanspruchs 1.

Derartige Energiespeicher dienen, sowohl als Einzelzellen, als auch in Form einer Batterie. mit beliebig vielen zusammengeschalteten Zellen, in vielfältiger Art und Weise als Traktions- und Starterbatterien für Land-, Luft- und Wasserfahrzeuge, sowie der Energieversorgung für eine Vielzahl von tragbaren und stationären Anlagen, von Maschinen- und Gerätesteuerungen, von Meßgeräten, Signal- und Warnanlagen und für Solarelektrisch betriebene Speicher.

In vielen der vorgenannten Anwendungsfälle wird zur Vermeidung einer Betriebsunterbrechung der durch einen elektrochemischen Energiespeicher betriebenen Einrichtungen, insbesondere eine kontinuierliche, hinreichend genaue, Ermittlung und Überwachung des Energieinhalts derartiger Energiespeicher erforderlich, denn nur mit einer genauen Kenntnis des jeweiligen Energieinhalts kann die Kapazität eines Energiespeichers voll ausgenutzt werden und eine, für einen Energiespeicher schädliche, Überschreitung oder Unterschreitung bestimmter Ladungs- oder Entladungsgrenzen vermieden werden. Dabei soll sichergestellt sein. daß das Verfahren mit einfachen Mitteln durchführbar ist und die Einrichtung zur Ermittlung des Energieinhalts übersichtlich und zweckmäßig bedienbar ist.

Die WO 86/00418 beschreibt ein Verfahren zur Überwachung des Ladezustandes von aufladbaren Batterien, insbesondere von Nickel-Cadmium-Akkumulatoren, wobei dort ein, einem bestimmten Ladezustand entsprechender, Referenzwert gespeichert, die Klemmenspannung. die Stromstärke und die Zeit während jedes Lade- und Entladezykluses der Batterie, gemessen und unter Berücksichtigung der Stromrichtung in eine, der zugeführten, bzw. verbrauchten Energiemenge entsprechende, Größe umgesetzt werden, aus der, ausgehend von dem Referenzwert, die Ladezustands-Istwerte berechnet werden und die Änderungsgeschwindigkeit der Klemmenspannung im Lade- und Entladezyklus überwacht wird und wobei nach Durchlaufen einer Phase relativ gleichmäßiger und geringer Spannungsänderungsgeschwindigkeit, wenigstens ein Zeitpunkt bestimmt wird, bei dem eine charakteristische stärkere Spannungsänderungsgeschwindigkeit auftritt und wobei der berechnete Ladezustands-Istwert zu diesem, oder einem definierten verzögerten Zeitpunkt auf den vorgegebenen Referenzwert abgeglichen wird.

Zur Durchführung dieses bekannten Verfahrens ist dort eine Einrichtung mit Anordnungen zur Messung der Klemmenspannung der Batterie, der Richtung und Amplitude des Lade-, bzw. Entladestroms und der Batterietemperatur, sowie eine programmgesteuerte Recheneinheit erforderlich, die mit den Meßanordnungen verbunden und so gesteuert ist, daß sie die Änderungsgeschwindigkeit der Klemmenspannung während aller Lade- und Entladezyklen der Batterie überwacht und einen Ladezustands-Istwert dann bestimmt, wenn die Spannungsänderungsgeschwindigkeit nach einer, im wesentlichen konstanten Phase, eine stärkere Änderung erfährt. Außerdem Ist dort ein Speicher erforderlich, der zur Speicherung von Referenzwerten und der, in der Recheneinheit entwickelten Istwerte der zugeführten, bzw. verbrauchten Energiemengen mit der Recheneinheit verbunden ist. Darüberhinaus sind eine Schnittstellen- und Treiberschaltung zur Kopplung der Recheneinheit mit peripheren Ein- und Ausgabegeräten notwendig.

Dieses Verfahren ist mit dem erheblichen Nachteil behaftet, daß dort zur Ermittlung des Ladezustandes u.a., eine Messung des Lade-, bzw. Entladestroms erforderlich ist, und daß zu diesem Zweck in den Stromkreis der Batterie ein Präzisionswiderstand geschaltet werden muß, an dem der erforderliche diesbezügliche Referenzwert ermittelt wird. Außerdem ist der erforderliche erhebliche meßtechnische Aufwand von Nachteil, der einen wirtschaftlichen Einsatz nur in entsprechenden Großanlagen sinnvoll erscheinen läßt.

Auch ein, aus der DE-OS 34 16 849 bekanntgewordenes, Verfahren mit einer Anordnung zum Messen des Ladezustandes von Batterien, benutzt zur Approximierung des Ladezustandes der zu messenden Batterieanlage, einen initialisierten Amperstundenzähler, ausgehend von einer vollständig aufgeladenen Batterie, wobei das Ausgangssignal des Zählers dem wahren Ladezustand der Batterieanlage eng genug folgt.

Dieses Verfahren ist ebenfalls mit dem Nachteil des Eingriffs in den Stromkreis der Batterieanlage behaftet, zumal der dort an einem Meßshunt ermittelte Strom, nur bei einer hinreichend konstanten Belastung der Batterie, eine Berechnung zusammen mit anderen Reaktionswerten hinreichend zuläßt.

Aus der EP-A-0 003 917 bzw. DE-A-29 52 853 ist ein Verfahren zur Bestimmung der Kapazität eines Akkumulators bekannt geworden, das die im wesentlichen folgenden Schritte umfaßt:

1) Es wird zunächst die Leerlaufspannung erfaßt;
2) Der Wert der anfänglichen Leerlaufspannung wird gespeichert;
3) Die Klemmenspannung des belasteten Akkumulators wird erfaßt;
4) Aus den Werten gemäß Ziff. 1) und 3) wird die Differenz bestimmt;
5) Aus der Differenz gemäß Ziff. 4) wird ein Wert für die Stromentnahme hergeleitet, welcher gemäß
6) ein Maß für die Kapazität des Akkumulators ist.

Bei diesem Verfahren wird die gespeicherte Leerlaufspannung in Abhängigkeit von der Leerlaufspannung-Lastspannung dynamisch geändert. Diese gleitende Leerlaufspannung dient als Maß für die Kapazität des Akkumulators.

Außerdem ist aus der DE-PS 29 26 716 ein Prüfverfahren für Gleichstromquellen, wie Akkumulatoren, Batterien, oder dergl., bekannt, bei welchem man den Wechselstrominnenwiderstand der zu prüfenden Gleichstromquelle als Kenngröße für deren Zustand mißt. Dabei wird zusätzlich die Leerlaufspannung der Gleichstromquelle gemessen und durch Paarung der gemessenen Werte der Leerlaufspannung einerseits und des Innenwiderstandes andererseits, in einander zugeordneten charakteristischen funktionellen Verknüpfungen der Leerlaufspannung in Abhängigkeit von der Ampere-Stunden-Kapazität, bzw. des Wechselstrominnenwiderstandes in Abhängigkeit von der Ampere-Stunden-Kapazität für jeweils unterschiedliche physikalische Zustände einer Gleichstromquelle desgleichen Typs wie der Prüfling, eine getrennte Aussage über Ladezustand einerseits und physikalischen Zustand andererseits gewonnen.

Zur Durchführung dieses Verfahrens ist ein technisch relativ aufwendiges elektronisches Prüfgerät, mit insbesondere einer komplizierten Widerstandsmeßeinrichtung, zur Bestimmung des Wechselstrominnenwiderstandes einer Gleichstromquelle, sowie ein Konstantstromgenerator mit konstanter Frequenz von 100 Hz und ein selektiver Spannungsverstärker, der auf die Frequenz des Konstantstromgenerators abgestimmt ist, erforderlich.

Auch das, in der DE-PS 30 31 898 beschriebene, Verfahren zur Ermittlung des Ladezustandes einer aus mehreren Untereinheiten mit jeweils mindestens einer Akkumulatorenzelle aufgebauten Akkumulatorenbatterie, bei dem die Spannung an den einzelnen Untereinheiten gemessen wird, ist aufgrund des dort erforderlichen technischen Aufwandes und des Bedienungsumfangs für einen einfach zu handhabenden Umgang und einen wirtschaftlichen Einsatz nicht geeignet, zumal dort diejenige Untereinheit ausgewählt werden muß, die die niedrigste Batteriespannung aufweist, wobei man aus dieser niedrigsten Batteriespannung dann den Gesamt-Ladezustand der ganzen Akkumulatorenbatterie entsprechend der Ladecharakteristik berechnet und den Gesamt-Ladezustand anzeigt.

Der Erfindung liegt die Aufgabe zugrunde, ein Verfahren der eingangsgenannten Art, zur Ermittlung des Energieinhaltswertes von elektrochemischen Energiespeichern zu schaffen, welches nur mit einer Messung der Klemmenspannung eines Energiespeichers und der Kenntnis der Entlade-Charakteristik des zu messenden Energiespeichers arbeiten soll. Dabei soll sichergestellt sein, daß der Energieinhaltswert eines gemessenen elektrochemischen Energiespeichers in Prozent, oder in einer Leistungseinheit, oder in einer Wegstrecke, oder in einer Zeiteinheit, oder einem Arbeitstakt, angezeigt wird.

Diese Aufgabe wird mit den Merkmalen im kennzeichnenden Teil des Patentanspruchs 1 gelöst.

Vorteilhaft bei diesem neuen Verfahren und der Einrichtung zur Durchführung dieses Verfahrens ist nicht nur, daß dort kein Eingriff in den Laststromkreis eines zu messenden Energiespeichers notwendig ist, daß dort die Genauigkeit des ermittelten Energieinhaltswertes unabhängig von der Belastung eines Energiespeichers ist, daß sich das Alter und die Umgebungstemperatur eines Energiespeichers im Wert der gemessenen Klemmenspannung ausdrückt und im ermittelten Energieinhaltswert damit voll berücksichtigt wird, daß dort der noch zur Verfügung stehende Energieinhaltswert und/oder die restliche Entladezeit vorausschauend angezeigt werden kann, insbesondere unter der Annahme, daß sich die durchschnittliche Belastung des Energiespeichers seit dem Beginn der Entladung nicht wesentlich ändern wird, sondern auch, daß der, im wesentlichen einfache, apparatetechnische Aufwand im wirtschaftlichsten Falle und mit ausreichender Genauigkeit nur aus einem spannungsmessenden Instrument bestehen kann, das mit einer speziellen Skala ausgestattet ist, dessen Meßbereichseinteilung von den jeweiligen Bezugswerten bestimmt ist.

Vorteilhaft ist ferner die einfache Gewinnung der Bezugswerte aus der jeweils gemessenen Klemmenspannung und dem relativen Energieinhaltswert, bezogen auf die, verschiedenen Entladeströmen entsprechenden, statischen Entladekennlinien, die in einem Rechner abgespeichert sind, aus denen der bestimmte, dem relativen Energieinhaltswert entsprechende Funktionswert, durch Interpolation der einzelnen Bezugswerte, berechnet wird und auf den sich die gemessene Klemmenspannung bei der Ermittlung des Energieinhaltswertes bezieht. Vorteilhaft ist hier auch ein speziell entwickeltes Rechnerprogramm unter Benutzung des Neville'schen Algorithmus zur Bestimmung des Funktionswertes aus den einzelnen Bezugswerten.

Wie das Verfahren zur Durchführung des Verfahrens im einzelnen gedacht ist, wird anhand einiger Diagramme und Ausführungsbeispielen in den Zeichnungen im folgenden näher erläutert. Es zeigen

Fig. 1    eine Darstellung eines Funktionsdiagramms mit mehreren statischen Entladekennlinien, mit einzelnen Bezugswerten und einem, daraus interpolierten, Funktionswert,

Fig. 2    eine Darstellung eines Funktionsdiagramms mit einer Schar statischer Entladekennlinien, wie sie den technischen Unterlagen eines Energiespeichers entsprechen, die vom Hersteller eines Energiespeichers geliefert werden,

Fig. 3    eine Darstellung eines Funktionsdiagramms mit der Klemmenspannung UKL als Funktion des relativen Energieinhaltswertes EIW in Prozent, für verschiedene Entladeströme EI,

Fig. 4    eine Darstellung eines Funktionsdiagramms mit der Klemmenspannung $U_{KL}$ als Funktion des Entladestroms EI für verschiedene relative Energieinhaltswerte EIW in Prozent,

Fig. 5     eine Darstellung eines räumlichen Funktionsdiagramms mit der Klemmenspannung $U_{KL}$ als Funktion des Energieinhaltswertes EIW in Prozent für verschiedene Bezugswerte BW und daraus errechneten Funktionswerten,

Fig. 6     ein Blockschaltbild eines einfachen, durch einen Energiespeicher versorgten Laststromkreis mit einem, zum Energiespeicher parallel geschalteten Meßinstrument zur Ermittlung des Energieinhalts eines Energiespeichers,

Fig. 7     eine schaubildliche Darstellung einer Einrichtung zur Ermittlung des Energieinhaltswertes EIW, mit zwei spannungsmessenden Instrumenten,

Fig. 8     eine schaubildliche Darstellung einer Einrichtung zur Ermittlung des Energieinhaltswertes EIW mit nur einem spannungsmessenden Instrument,

Fig. 9     eine Darstellung eines Instrumentes für eine Einrichtung nach Fig. 7 und 8, mit einer Wechselskala,

Fig. 10     eine Ansicht eines Meßgerätes zur Anzeige des Energieinhaltswertes EIW und

Fig. 11     ein Blockschaltbild einer Einrichtung zur Ermittlung des Energieinhaltswertes EIW mit einem Rechner mit Halbleiterspeicher und mit Anzeige-, Signal- und Ein/Ausgabevorrichtungen, im Einsatz an einem, durch einen Energiespeicher betriebenen, Gerät.

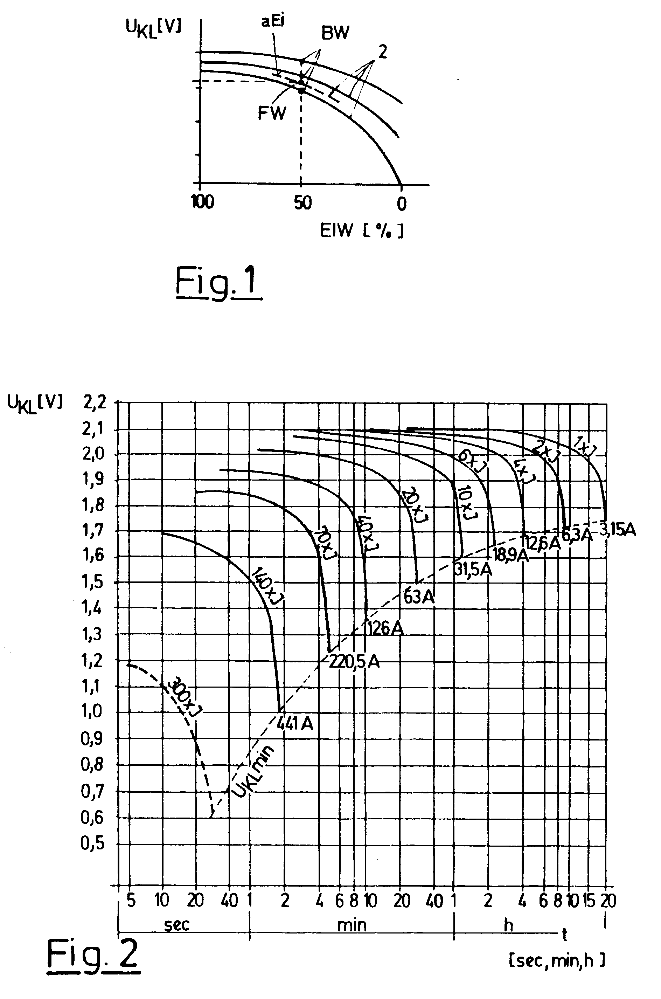

In dem Funktionsdiagramm, gemäß der Fig. 1, ist auf der Ordinatenachse die Klemmenspannung $U_{KL}$, in Volt, und auf der Abszissenachse der relative Energiehaltswert EIW, in Prozent, aufgetragen. 2 bezeichnet dort Entladestrom-Kennlinien. BW bezeichnet Bezugswerte die auf den einzelnen Kennlinien 2 liegen die verschiedenen Entladeströmen entsprechen und die in einem Rechner abgespeichert sind.

Wie die Figur zeigt, bestimmen, gemäß der Funktion $U_{KL}=f(EIE,aEI)$, die gemessene Klemmenspannung $U_{KL}$ und der relative Energieinhaltswert EIW einen Funktionswert FW, der einem angenommenen Entladestrom aEI entspricht. Damit kann, gemäß dem neuen Verfahren, dieser angenommene Entladestrom aEI, zusammen mit den, dem momentanen relativen Energieinhaltswert EIW entsprechenden Bezugswerten BW aus dem Feld der Kennlinien 2, sowie der gemessenen Klemmenspannung $U_{KL}$, durch Interpolation der einzelnen Bezugswerte BW, berechnet werden, sodaß damit der Energieinhaltswert EIW eines Energiespeichers ermittelt werden kann.

Dieser ermittelte Energieinhaltswert EIW bringt zum Ausdruck, wieviel elektrische Energie, in Prozent, im Energiespeicher bereits verbraucht, oder wieviel Energie noch vorhanden ist. Dabei beginnt die Ermittlung des Energieinhaltswertes EIW immer mit einem 100%igen Rest-Energieinhaltswert, bezogen auf einen bestimmten Betriebsspannungsbereich des Energiespeichers.

Die Fig. 2 zeigt ein Funktionsdiagramm mit der Klemmenspannung $U_{KL}$ als Funktion der Entladezeit in (sec, min, h), für verschiedene Entladeströme. Die Klemmenspannung $U_{KL}$ ist dabei wieder auf der Ordinatenachse und die Entladezeit auf der Abzissenachse aufgetragen. Die dortigen EntladeKennlinien 2 repräsentieren den Nennzustand eines Energiespeichers. Funktionsdiagramme, gemäß der Fig. 2, werden von den Herstellern chemischer Energiespeicher herausgeben.

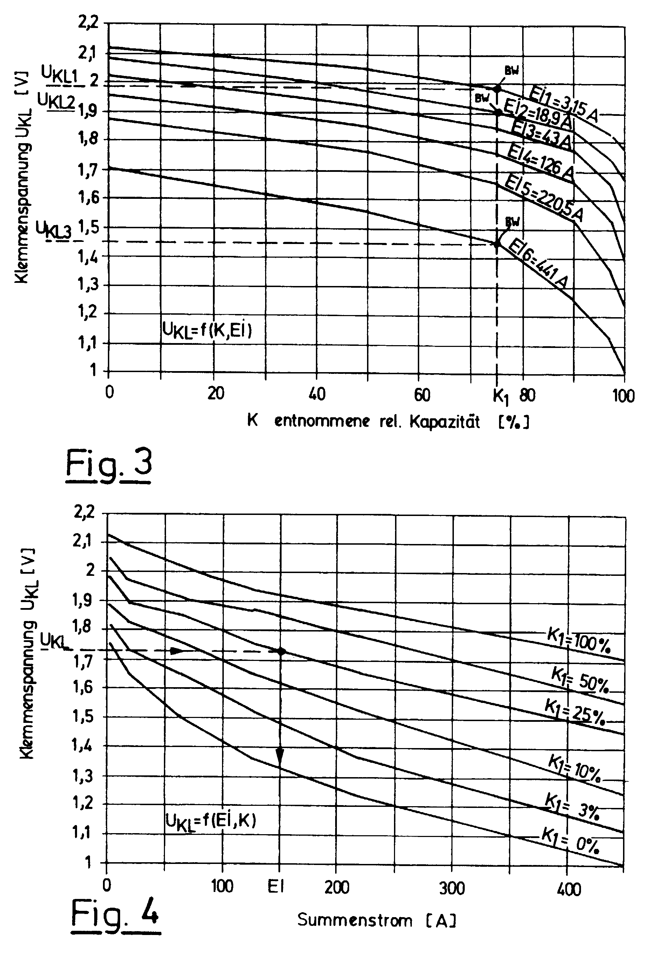

Aus der Fig. 3 ist ein Funktionsdiagramm ersichtlich, bei der zur Ermittlung des Energieinhaltswertes EIW, mit der Klemmenspannung $U_{KL}$ als Funktion der relativen Kapazität K, in Prozent, für verschiedene Entladeströme EI, entsprechend $U_{KL}=f(K,EI)$. Wie die Figur zeigt, ist die Abszissenachse invertiert d.h. 100% - K.

Eine andere Darstellung ist aus dem Funktionsdiagramm der Fig. 4 ersichtlich, in dem für einige relative Energieinhalts-Kapazitäten K, die Klemmenspannung $U_{KL}$ über dem Entladestrom EI aufgetragen ist, gemäß $U_{KL}=f(EI,K)$. Diese Beziehung wird benötigt, wenn aus der gemessenen Klemmenspannung UKL der Entladestrom EI berechnet werden soll.

Eine Ermittlung oder Berechnung eines Energieinhaltswertes beginnt immer mit einer Restkapazität von 100%. 100% Restkapazität können je nach Ladezustand eines Energiespeichers, am Anfang der Entladung, verschiedene Kapazitäten, bzw. Energieinhaltswerte EIW bedeuten. Diese Restkapazität bzw. der Restenergieinhaltswert EIW, in Prozent, und die Klemmenspannung $U_{KL}$ bestimmen einen Bezugswert BW im Feld der Kennlinien 2, der einem angenommenen Entladestrom EI entspricht. Dieser Strom stimmt in fast allen Fällen nicht mit dem meßbaren wirklichen Entladestrom EI überein.

Der angenommene Entladestrom EI wird mit den, dem momentanen Stützpunkten aus dem Feld der Kennlinien 2, der Fig. 3, und der aktuellen Klemmenspannung $U_{KL}$ durch Interpolation berechnet, wie das folgende Beispiel zeigt:

Der momentane relative Restenergieinhaltswert EIW oder die relative Restkapazität sei K = 25%, daraus folgt wegen Invertierung

$K_1$ = 100% - 25% = 75%. Dieser Wert ergibt Schnittpunkte mit den drei Kennlinien

$$U_{KL}1 = 1,98V; EI_1 = 3,15A$$

$$U_{KL}2 = 1,90V; EI_2 = 18,90A$$

$$U_{KL}3 = 1,45V; EI_3 = 441 A$$

Diese Schnittpunkte = Bezugswerte BW sind Stützpunkte einer Kennlinie 2 in der Fig. 3.

Mit der aktuell gemessenen Klemmenspannung UKL von beispielsweise $U_{KL} = 10,3V$ folgt wegen der sechs (6) Zellen des Energiespeichers eine Klemmenspannung $U_{KL}$ pro Zelle von $U_Z = U_{KL}/6 = 1,717V$. Mit diesem Argument wird der angenommene Entladestrom EI interpoliert, sodaß ein Wert von EI = 150A erzielt wird.

Mit diesem berechneten Entladestrom EI wird die während der Dauer T des Meßintervalls verbrauchte absolute Kapazität $K_v$ berechnet, sodaß $K_v = EI \times T = 150A \times 10sec = 0,417Ah$ ist.

Der zur Verfügung stehende maximale Energieinhaltswert EIW, oder die maximale Kapazität K ist beim Energiespeicher 1 von der Belastung abhängig. Die Nennkapazität kann nur bei Belastung mit dem Nennstrom entnommen werden. Der erreichbare Entladegrad, der bei Nennbelastung gleich eins (1) ist, fällt bei größeren Entladeströmen bis auf Werte von 0,2 ab. Dies ist auf ein Blockierungseffekt infolge der geringen Diffusionsgeschwindigkeit des Elektrolyten zurückzuführen. Der konzentrierte Elektrolyt zwischen den Platten des Energiespeichers kann nicht schnell genug in die Poren der Platten nachdiffundieren. Es kommt zu einer Säureverarmung in den Poren der Platten. Damit steigt der Elektrolytwiderstand stark an, die Klemmenspannung bricht zusammen und es kommt zu einem frühzeitigen Entladeschluß.

Dem Programm zur Berechnung des Energieinhaltswertes EIW sind also die maximalen Kapazitätswerte für verschiedene Entladeströme EI, etwa die neun (9) Datenblattkennlinien 2, aus der Fig. 2, bekannt. Der dortige Entladestrom EI der Kennlinien 2 multipliziert mit der maximal erreichbaren Entladezeit T ergibt die maximale Kapazität $K_{max}$. Mit diesen Stützpunkten und insbesondere unter Ausnutzung des Neville'schen Algorithmus wird eine weitere Kennlinie 2 interpoliert und die zum angenommenen Entladestrom EI von 150A gehörige maximale Kapazität mit $K_{max} = 22Ah$ berechnet.

Das Verhältnis von Kv zu $K_{max}$ ergibt die während der Dauer des Meßintervalls verbrauchte relative Kapazität, welche nun von der zuletzt berechneten relativen Restkapazität abgezogen, eine neue Restkapazität ergibt. Entsprechend ist $K = 25\% - (0,417/22) \times 100\% = 23,1\%$. Diese Berechnung wiederholt sich, bis eine gewählte untere Grenze, beispielsweise 20% Restkapazität, unterschritten ist.

Gemäß dem vorliegenden Verfahren wird, in Abhängigkeit vom Betriebszustand und der Belastung des Energiespeichers 1, der richtige Zeitpunkt berechnet, wann keine Ladung mehr entnommen werden darf, um Tiefentladungen zu vermeiden. Die Einflußgrößen, wie die Alterung, die Elektrolyttemperatur und der Ladegrad, drücken sich in der Größe der Klemmenspannung $U_{KL}$ und somit auch im berechneten Funktionswert FW aus.

Zur Verdeutlichung dieser Tatsache werden zwei zueinander unterschiedliche Fälle aufgezeigt:

1. Ist der Energiespeicher 1 neu und/oder vollgeladen und/oder die Elektrolyttemperatur höher als die Nenntemperatur, dann wird aufgrund der dort gemessenen höheren Klemmenspannung $U_{KL}$ ein kleinerer Funktionswert FW berechnet, als dies im Nennzustand der Fall wäre.

2. Ist der Energiespeicher 1 nicht mehr neu und/oder nicht vollgeladen und/oder die Elektrolyttemperatur niedriger als die Nenntemperatur, dann wird aufgrund der dort gemessenen niedrigeren Klemmenspannung $U_{KL}$ ein größerer Funktionswert FW berechnet.

Im Fall 1. kann länger entladen werden, als unter den Bedingungen des Nennzustandes oder denen des Falls 2.

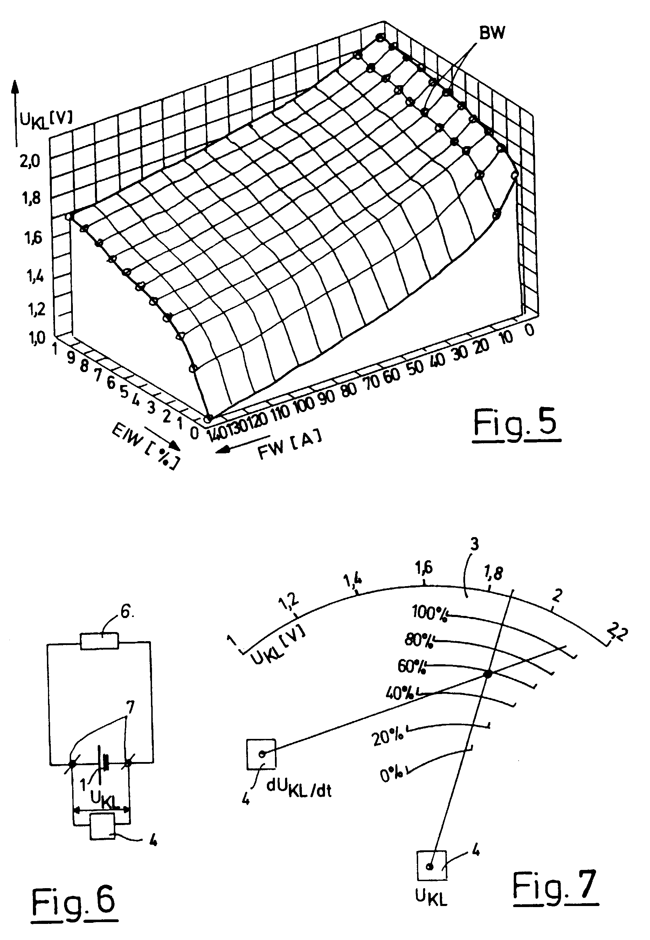

Aus der Fig. 5 ist ein räumliches Funktionsdiagramm ersichtlich. Dort kann auf der dargestellten Oberfläche jeder beliebige Funktionswert FW liegen. BW bezeichnet dort die Bezugswerte, EIW die Achse für den Energieinhaltswert, in Prozent. $U_{KL}$ die Funktionsachse für die Klemmenspannung.

Die Fig. 6 zeigt einen einfachen Stromkreis mit einem Energiespeicher 1 und einem Verbraucher 6. 4 bezeichnet ein Instrument zur unmittelbaren Ermittlung des Energieinhaltswertes EIW durch die Messung der Klemmenspannung $U_{KL}$ an den Klemmen 7 des Energiespeichers 1.

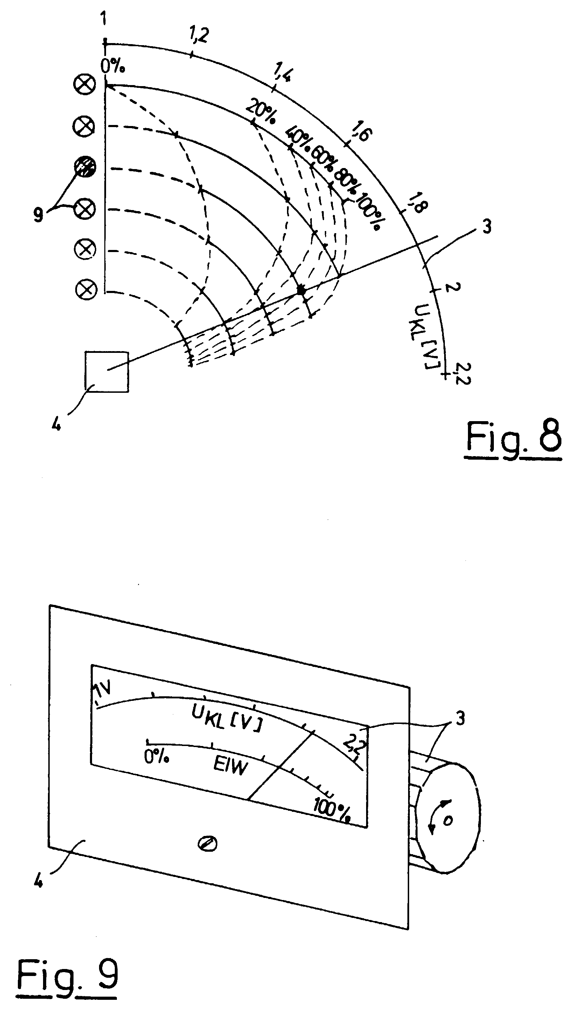

In der einfachsten Ausführung kann eine Einrichtung zur Ermittlung des Energieinhaltswertes EIW aus einem spannungsmessenden Instrument 4, insbesondere einem Zeigerinstrument, bestehen, das, wie die Fig. 8 zeigt, mit einer Skala 3 ausgestattet sein kann, die mit mehreren Bereichen 8 versehen ist, die unterschiedlichen Entladeströmen EI, bzw. entsprechenden Bezugswerten BW / Funktionswerten FW entsprechen können. Der jeweilige, der Messung zugrunde liegende Entladestrom EI, bzw. Bezugswert BW, oder Funktionswert FW, kann dort von einem optischen Signal 9 signalisiert werden.

Es kann vorgesehen sein, daß die einzelnen Meßbereiche 8 manuell mechanisch oder selbsttätig elektronisch vorwählbar sind, wie dies aus der Fig. 9 ersichtlich ist.

Es ist auch daran gedacht, mit zwei Instrumenten 4 eine Ermittlung des Energieinhaltswertes EIW auf der Basis einer Messung der Klemmenspannung $U_{KL}$ vorzunehmen, wie die Fig. 7 zeigt. Dort wird mit dem zweiten Zeigermeßwerk die optische Anzeige nach der Ausführung gemäß der Fig. 8 ersetzt. Der Schnittpunkt der beiden Zeiger 10 zeigt den Energieinhaltswert EIW auf dem jeweils gültigen Bereich 8 an.

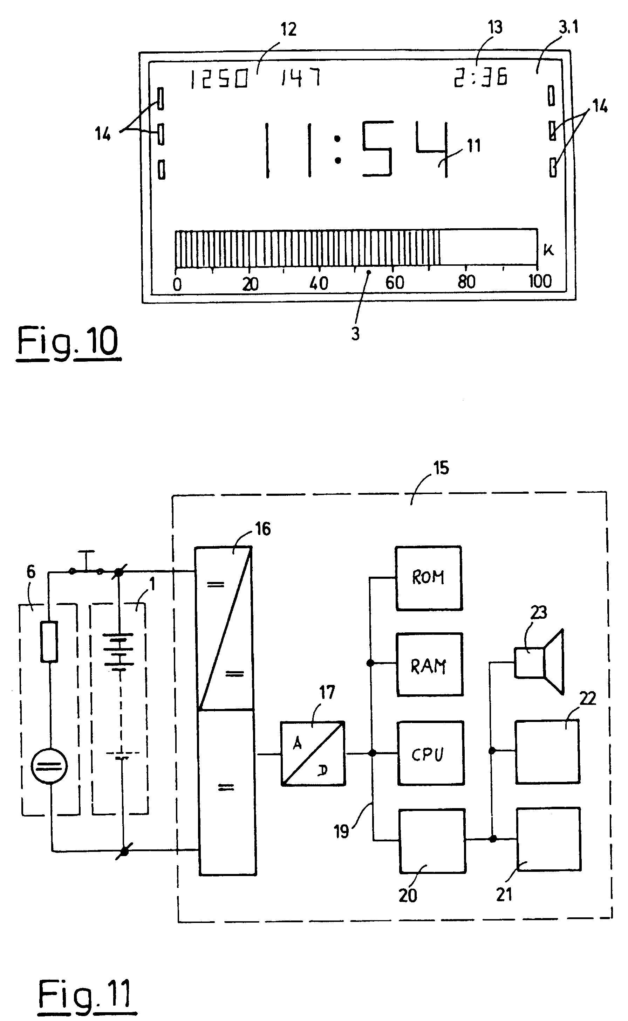

Die Fig. 10 zeigt ein Meßgerät für ein Elektrofahrzeug mit einer analogen Anzeigevorrichtung an einer, in Prozent, geeichten Skala 3, an der die prozentuale Restkapazität K abgelesen werden kann. In diesem Meßgerät kann außerdem die Uhrzeit 11 und/oder die Betriebsstunden 12 und/oder die Zyklenzeit 13 angezeigt werden. Weitere Anzeigen 14 für Zellen-, Außen- und Motortemperatur können vorgesehen sein. Derartige Meßgeräte können in Elektrofahrzeugen allgemein, insbesondere in elektrisch angetriebenen Gabelstaplern nützlich sein. Die Anzeigen können in digitaler Form erfolgen. Die gesamte geräteseitige Skala 3.1 kann insbesondere ein LCD-Anzeigemodul sein.

Aus der Fig. 11 ist ein Blockschaltbild einer elektronischen, rechnergesteuerten Einrichtung zur Ermittlung des Energieinhaltswertes EIW ersichtlich. 1 bezeichnet einen Energiespeicher mit einer Last 6 im Stromkreis. 15 kennzeichnet den elektronishen Teil der Einrichtung, mit einer Stromversorgung 16, zur Versorgung der Einrichtung, mit einem Analog-Digital-Wandler 17, zur Aufbereitung der gemessenen Klemmenspannung $U_{KL}$, dessen Information über einen Datenbus 19 der Zentraleinheit CPU zugeführt werden, die auf das Befehlsregister mit den abgespeicherten Bezugswerten BW von mindestens drei Kennlinien 2, inform von Einzelbezugswerten EBW, in der Berechnung des Energieinhaltswertes EIW zurückgreift. Im RAM werden die berechneten Werte, in Prozent, in einer Zeiteinheit, in Arbeitstakten, oder in einer Leistungseinheit, abgespeichert. Über eine Schnittstelle 20 sind Ein-/Ausgangsgeräte 21, wie eine Tastatur zur Dateneingabe, ein Magnetkartenleser zur Dateneingabe, ein optoelektronischer Leser zur Dateneingabe, ein Drucker zur Datenausgabe, oder ein Koordinatenschreiber zur Datenausgabe, anschließbar. Außerdem sind an diese Schnittstelle 20 Anzeigeeinrichtungen 22, zur unmittelbaren Anzeige von Aus- und/oder Eingabewerten, anschließbar. Desweiteren können dort optische und/oder akustische Signalgeber 23 angeschlossen werden, welche insbesondere bei einem Energieinhaltswert EIW von null (0) im Energiespeicher 1 ein Signal abgeben.

Die elektronische Einrichtung nach dem Blockschaltbild der Fig. 11, beschränkt sich nicht auf die dort gezeigte und beschriebene Hardware, sondern ist sowohl hinsichtlich des Festwertspeichers ROM, als auch des Schreib-Lese-Speichers RAM beliebig, den Erfordernissen entsprechend, erweiterbar. So ist es insbsondere vorgesehen, daß die Einzelbezugswerte EBW der statischen Kennlinien 2 aus dem Datenblatt, gemäß der Fig. 2, inform einer oder mehrerer rechteckiger Matritzen im Speicher-ROM abgelegt sind, und daß dort die abgespeicherten Spalten dem Energieinhaltswert EIW, insbesondere in Prozent, und die abgespeicherten Zeilen den Einzelbezugswerten EBW der Kennlinie 2 entsprechen. Dabei ist es vorgesehen, daß die Einzelbezugswerte EBW zur Bildung eines Funktionswertes FW in beliebiger Anzahl für die jeweilige spezifische Ermittlung des Energieinhaltswertes EIW berechnet werden können.

Das vorliegende Verfahren und die erwähnten Einrichtungen eignen sich nicht nur zur Ermittlung des Energieinhaltswertes EIW von elektrochemischen, aufladbaren oder nicht aufladbaren, Energiespeichern, sondern auch zur Ermittlung des Energieinhaltswertes von statischen Energiespeichern, wie dies Kondensatoren zum Speichern einer elektrischen Ladung darstellen.

## Patentansprüche

1. Verfahren zur Ermittlung des Energieinhaltswertes (EIW) von elektrochemischen Energiespeichern (1) unter Verwendung des zuletzt ermittelten Energieinhaltswertes (EIW) und der gemessenen Klemmenspannung ($U_{KL}$) aus einer Schar Entladekennlinien (2) mit zueinander unterschiedlichen Entladeströmen (El), deren Ausgangspunkte der Nennkapazität, gleich einem 100%igen Energieinhaltswert (EIW), und deren Endpunkte dem Entladeende, gleich einem 0%igen Energieinhaltswert (EIW) des Energiespeichers (1) entsprechen, **dadurch gekennzeichnet,** daß die gemessene Klemmenspannung ($U_{KL}$) eine Funktion (f) des relativen Energieinhaltswertes (EIW), in Prozent, für verschiedene, seit der letzten Energieinhaltsermittlung konstant gebliebene, Entladeströme (El), entsprechend den Entladekennlinien (2), ist und daß der angenommene Entladestrom (aEl) mit den, dem momentanen relativen Energieinhaltswert (EIW) entsprechenden, Bezugswerten (BW) aus der Schar der Entladekennlinien (2) und der gemessenen Klemmenspannung ($U_{KL}$) durch Interpolation der einzelnen Bezugswerte (BW) ermittelt, und mit dem, seit dem letzten Ermittlungsvorgang vergangenen, Zeitintervall (T) multipliziert wird und das daraus resultierende Ergebnis vom letzten Energieinhaltswert (EIW) abgezogen wird.

## Claims

1. A method of determining the energy content value (EIW) of electrochemical energy stores (1) using the last determined energy content value (EIW) and the measured terminal voltage ($U_{KL}$) from a family of discharge curves (2) with mutually differing discharge currents (El), the starting points of which correspond to the nominal capacity, equivalent to a 100% energy content value (EIW) and the end points of which correspond to the end of the discharging process, equivalent to a 0% energy content value (EIW) of the energy store(1), characterised in that the measured terminal voltage ($U_{KL}$) is a function (f) of the relative energy content value (EIW), in percentage, for different discharge currents (El) which have remained constant since the last energy content determination, in accordance with the discharge curves (2), and that the assumed discharge current (aEl) is determined with the reference values (BW) corresponding to the instantaneous, relative energy content value (EIW) from the family of discharge curves (2) and from the measured terminal voltage($U_{KL}$) by interpolation of the individual reference values (BW) and is multiplied by the time interval (T) which has elapsed since the last determination process, and the result is subtracted from the last energy content value (EIW).

**Revendications**

1.   Procédé pou déterminer le contenu énergétique (EIW) d'accumulateurs électrochimiques (1), avec utilisation de la dernière valeur du contenu énergétique (EIW) obtenue et de la tension mesurée aux bornes ($U_{KL}$) à partir d'une cohorte de courbes de décharge (2) à intensités (EI) de décharge différentielles dont les points initiaux correspondent à la capacité nominale égale à 100 % de la valeur du contenu énergétique (EIW) et dont les points d'extrémité correspondent à la décharge complète égale à 0 % de la valeur du contenu énergétique (EIW) de l'accumulateur (1), caractérisé en ce que la tension mesurée aux bornes ($U_{KL}$) est fonction (f) de la valeur relative de contenu énergétique (EIW), en pourcent, pour plusieurs intensités de décharge (EI) restées constantes depuis la dernière détermination, conformément aux courbes de décharge (2), en ce que l'intensité de décharge supposée (aEI) est déterminée, en même temps que les valeurs de référence (BW) qui correspondent à la valeur momentanée relative du contenu énergétique (EIW) à partir de la cohorte de courbes de décharge (2) et de la tension mesurée aux bornes ($U_{KL}$) par interpolation des différentes valeurs de référence (BW), en ce qu'elle est multipliée avec l'intervalle de temps (T) écoulé depuis la dernière opération de détermination et en ce que le résultat de cette multiplication est soustrait de la dernière valeur de contenu énergétique (EIW).

Fig. 1

Fig. 2

Klemmenspannung $U_{KL}$ [V]

$U_{KL1}$ 2
$U_{KL2}$ 1,9

BW
BW Ei1 = 3,15 A
Ei2 = 18,9 A
Ei3 = 43 A
Ei4 = 126 A
Ei5 = 220,5 A

$U_{KL3}$ 1,5
BW
Ei6 = 441 A

$U_{KL} = f(K, Ei)$

K   entnommene rel. Kapazität   [%]

$K_1$

## Fig. 3

Klemmenspannung $U_{KL}$ [V]

$U_{KL}$

$K_1 = 100 \%$
$K_1 = 50 \%$
$K_1 = 25 \%$
$K_1 = 10 \%$
$K_1 = 3 \%$
$K_1 = 0 \%$

$U_{KL} = f(Ei, K)$

Ei

Summenstrom [A]

## Fig. 4

Fig.5

$U_{KL}[V]$

2,0
1,8
1,6
1,4
1,2
1,0

E/W [%]

FW [A]

BW

Fig.6

6.

7

1

$U_{KL}$

4

Fig.7

3

1,2  1,4  1,6  1,8  2  2,2

$U_{KL}[V]$

100%
80%
60%
40%
20%
0%

$dU_{KL}/dt$

4

$U_{KL}$

4

## Fig. 8

## Fig. 9

## Fig.10

## Fig.11